# EUROPÄISCHE PATENTSCHRIFT

(11) **EP 1 161 128 B1**
(45) Veröffentlichungstag und Bekanntmachung des Hinweises auf die Patenterteilung: **12.11.2003**
(21) Anmeldenummer: 01108577.6
(22) Anmeldetag: 05.04.2001
(51) Int. Cl.: H05K 9/00

(54) **Abgeschirmte, elektronische Schaltung**
Shielded electronic circuit
Circuit électronique blindé

(30) Priorität: 27.05.2000 DE 10026353
(43) Veröffentlichungstag der Anmeldung: 05.12.2001
(73) Patentinhaber: Siemens Aktiengesellschaft, 80333 München (DE)
(72) Erfinder: Spratte, Joachim, 49090 Osnabrück (DE); Reinhardt, Jörg, 35633 Lahnau (DE)

(56) Entgegenhaltungen:
- EP-A- 0 519 767
- EP-A- 0 632 686
- EP-A- 0 926 940
- PATENT ABSTRACTS OF JAPAN vol. 1998, no. 06, 30. April 1998 (1998-04-30) & JP 10 041678 A (HITACHI LTD), 13. Februar 1998 (1998-02-13)

## Beschreibung

Die Erfindung betrifft eine mit einer äußeren Abschirmung versehene elektronische Schaltung, welche innerhalb der äußeren Abschirmung zum Schutz vor einer gegenseitigen Beeinflussung elektronischer Bauteile zumindest eine innere Abschirmung aufweist.

Elektronische Schaltungen der vorstehenden Art sind in der Technik allgemein bekannt und gebräuchlich, beispielsweise in Kraftfahrzeugen für Fahrzeugnavigationsgeräte. Die Abschirmungen dienen dazu, die elektronischen Bauteile vor einer elektromagnetischen Beeinflussung von außen zu schützen und ein Abstrahlen von elektromagnetischen Wellen nach außen zu verhindern, damit die Schaltung keine fremden elektronischen Einrichtungen stören kann. Oftmals sind in einer Schaltung elektronische Bauteile vorhanden, bei denen die Gefahr einer gegenseitigen Beeinflussung besteht. Deshalb wird es nicht nur erforderlich, die Schaltung als Ganzes abzuschirmen, vielmehr muss man innerhalb der Abschirmung einzelne Bauteile für sich allein nochmals abschirmen. Wenn man innerhalb einer Abschirmung eine weitere Abschirmung vorsieht, dann bereitet die Abfuhr der Wärme der hierdurch doppelt abgeschirmten Bauteile Schwierigkeiten. In solchen Fällen könnte man daran denken, die innere Abschirmung mit Wärmeleitgummi mit der äußeren Abschirmung zu verbinden, damit die in die innere Abschirmung gelangende Wärme über den wärmeleitendem Material in die äußere Abschirmung fließen kann. Eine solche Verbindung der Abschirmungen über beispielsweise einen Wärmeleitgummi bedingt jedoch einen relativ hohen Montageaufwand und verlangt enge Toleranzen der Bauteile, damit nicht zu stark unterschiedliche Abstände zwischen den beiden Abschirmungen überbrückt werden müssen. Weiterhin ist die Wärmeleitung oftmals unzureichend, weil die Wärme zunächst von der einen Abschirmung in den Wärmeleitgummi hinein und dann von dem Wärmeleitgummi in die andere Abschirmung übergehen muss, bevor die äußere Abschirmung die Wärme an die Umgebungsluft abgeben kann.

Eine solche Verbindung ist zum Beispiel aus dem Dokument JP-A-10 041 678 (HITACHI) bekannt.

Der Erfindung liegt das Problem zugrunde, eine abgeschirmte elektronische Schaltung der eingangs genannten Art so zu gestalten, dass die in die innere Abschirmung gelangende Wärme optimal nach außen abgeführt werden kann, ohne dass die Schaltung deshalb mit hoher Genauigkeit gefertigt und aufwendig montiert werden muss.

Dieses Problem wird erfindungsgemäß dadurch gelöst, dass die äußere Abschirmung auf der inneren Abschirmung aufliegt und im Bereich der inneren Abschirmung eine Durchbrechung hat.

Durch diese Gestaltung wird die eigentliche Ursache für das Problem der schlechten Kühlung der inneren Abschirmung, nämlich die Abtrennung des elektronischen Bauteils innerhalb der inneren Abschirmung durch zwei Wände beseitigt. Durch die erfindungsgemäße Durchbrechung in der äußeren Abschirmung bildet die innere Abschirmung im Bereich der Durchbrechung zugleich die Wandfläche der äußeren Abschirmung. Deshalb kann die innere Abschirmung ihre Wärme unmittelbar nach außen hin abgeben, so dass man nicht mehr auf die Übertragung von Wärme aus der inneren Abschirmung in die äußere Abschirmung angewiesen ist.

Da aus Fertigungsgründen in der Praxis es zwischen der inneren Abschirmung und der äußeren Abschirmung stets zu beträchtlichen Abstandsschwankungen kommen kann, besteht die Notwendigkeit eines Toleranzausgleichs. Das lässt sich gemäß einer vorteilhaften Weiterbildung der Erfindung sehr einfach dadurch verwirklichen, dass die Durchbrechung der äußeren Abschirmung durch eine Vielzahl nebeneinander angeordneter Federzungen begrenzt ist, welche auf der inneren Abschirmung mit Vorspannung aufliegen.

Die Spalten zwischen den beiden Abschirmungen müssen mit Rücksicht auf die Wellenlängen der störenden Frequenzen bemessen sein. Das bereitet Schwierigkeiten, weil nicht klar vorausgesagt werden kann, mit welchen Bereichen die äußere Abschirmung auf der inneren Abschirmung aufliegt. Solche Unsicherheiten lassen sich vermeiden, wenn die äußere Abschirmung entlang des Randes der Durchbrechung mit kugelkalottenförmigen Eindrückungen auf der inneren Abschirmung aufliegt und die Abstände der Eindrückungen auf die Wellenlänge der störenden Frequenzen abgestimmt sind.

Besonders vorteilhaft ist es, wenn die Eindrückungen in den Federzungen vorgesehen sind.

Die Federzungen vermögen besonders große Abstandsunterschiede auszugleichen, wenn gemäß einer anderen Weiterbildung der Erfindung die Federzungen zum Ausgleich unterschiedlicher Höhenlagen der Abschirmungen z-förmig gebogen verlaufen.

Eine besonders gute Kühlwirkung und gleichzeitig ein möglichst geringes Bauvolumen ergibt sich, wenn die innere Abschirmung eine größere Höhe hat als die äußere Abschirmung und die z-förmigen Zungen der äußeren Abschirmung aus der Ebene der äußeren Abschirmung zur Ebene der inneren Abschirmung hochgeführt sind.

Die elektronische Schaltung ist als Ganzes optimal gestaltet, wenn die äußere Abschirmung auf einer Hauptleiterplatte befestigt ist, welche innerhalb der äußeren Abschirmung eine mit Abstand zu der Hauptleiterplatte parallel verlaufende Tochterleiterplatte mit zumindest einem weiteren, elektronischen Bauteil trägt und wenn die innere Abschirmung auf dieser Tochterleiterplatte befestigt ist.

Die Erfindung lässt verschiedene Ausführungsformen zu. Zur weiteren Verdeutlichung ihres Grundprinzips ist eine davon in der Zeichnung dargestellt und wird nachfolgend beschrieben. Die Zeichnung zeigt in
- Fig.1: einen Schnitt durch eine elektronische Schaltung nach der Erfindung,
- Fig.2: eine Draufsicht auf eine erfindungsgemäße elektronische Schaltung.

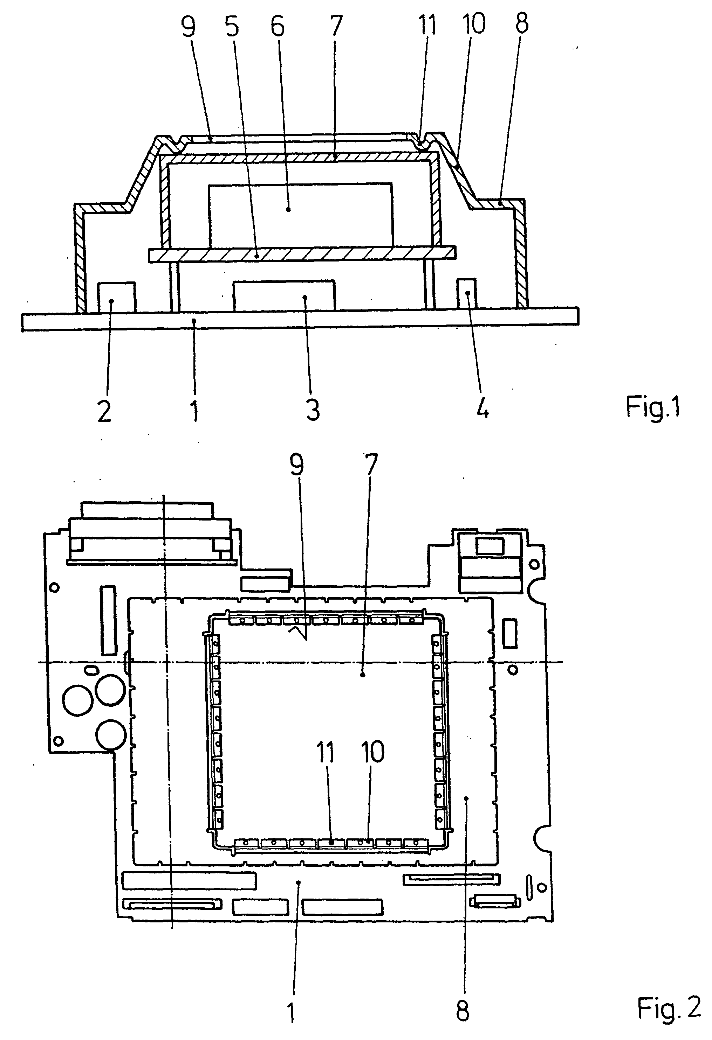

Die Figur 1 zeigt eine Hauptleiterplatte 1, auf der verschiedene elektronische Bauteile 2, 3, 4 angeordnet sind. Mit Abstand und parallel zur Hauptleiterplatte 1 ist auf ihr eine Tochterleiterplatte 5 mit einem elektronischen Bauteil 6 befestigt. Dieses elektronische Bauteil 6 wird von einer inneren Abschirmung 7 abgekapselt. Die gesamte elektronische Schaltung wird von einer äußeren Abschirmung 8 abgedeckt. Diese hat eine Durchbrechung 9, die von z-förmig hochgeführten Federzungen 10 begrenzt wird, welche jeweils eine kugelkalottenförmige Eindrückung 11 aufweist, die mit Vorspannung von oben her auf der inneren Abschirmung 7 aufliegt.

Die Figur 2 zeigt die Hauptleiterplatte 1 mit der darauf angeordneten äußeren Abschirmung 8. Weiterhin erkennt man die Durchbrechung 9, welche von den Federzungen 10 begrenzt ist, die jeweils mit ihrer Eindrückung 11 auf der inneren Abschirmung 7 mit Vorspannung aufliegt.

## Patentansprüche

1. Mit einer äußeren Abschirmung zum Schutz vor elektromagnetischen Wellen versehene elektronische Schaltung, in der elektronische Bauteile vorhanden sind, und welche innerhalb der äußeren Abschirmung zumindest eine innere Abschirmung aufweist, von welcher ein Bauteil zum Schutz vor einer gegenseitigen Beeinflussung der elektronischen Bauteile abgekapselt wird, **dadurch gekennzeichnet, dass** die äußere Abschirmung (8) auf der inneren Abschirmung (7) aufliegt und im Bereich der inneren Abschirmung (7) eine Durchbrechung (9) hat, so daß die innere Abschirmung im Bereich der Durchbrechung zugleich die Wandfläche der äußeren Abschirmung bildet.

2. Elektronische Schaltung nach Anspruch 1, **dadurch gekennzeichnet, dass** die Durchbrechung (9) der äußeren Abschirmung (8) durch eine Vielzahl nebeneinander angeordneter Federzungen (10) begrenzt ist, welche auf der inneren Abschirmung (7) mit Vorspannung aufliegen.

3. Elektronische Schaltung nach den Ansprüchen 1 oder 2, **dadurch gekennzeichnet, dass** die äußere Abschirmung (8) entlang des Randes der Durchbrechung (9) mit kugelkalottenförmigen Eindrückungen (11) auf der inneren Abschirmung (7) aufliegt und die Abstände der Eindrückungen (11) auf die Wellenlänge der störenden Frequenzen abgestimmt sind.

4. Elektronische Schaltung nach Anspruch 3, **dadurch gekennzeichnet, dass** die Eindrückungen (11) in den Federzungen (10) vorgesehen sind.

5. Elektronische Schaltung nach zumindest einem der vorangehenden Ansprüche, **dadurch gekennzeichnet, dass** die Federzungen (10) zum Ausgleich unterschiedlicher Höhenlagen der Abschirmungen (7, 8) z-förmig gebogen verlaufen.

6. Elektronische Schaltung nach zumindest einem der vorangehenden Ansprüche, **dadurch gekennzeichnet, dass** die innere Abschirmung (7) eine größere Höhe hat als die äußere Abschirmung (8) und die z-förmigen Zungen (10) der äußeren Abschirmung (8) aus der Ebene der äußeren Abschirmung (8) zur Ebene der inneren Abschirmung (7) hochgeführt sind.

7. Elektronische Schaltung nach zumindest einem der vorangehenden Ansprüche, **dadurch gekennzeichnet, dass** die äußere Abschirmung (8) auf einer Hauptleiterplatte (1) befestigt ist, welche innerhalb der äußeren Abschirmung (8) eine mit Abstand zu der Hauptleiterplatte (1) parallel verlaufende Tochterleiterplatte (5) mit zumindest einem weiteren, elektronischen Bauteil (6) trägt und dass die innere Abschirmung (7) auf dieser Tochterleiterplatte (5) befestigt ist.

## Claims

1. Electronic circuit in which electronic components are present, which is provided with an outer shielding for protecting against electromagnetic waves and which has, within the outer shielding, at least one inner shielding, by which a component is encapsulated for preventing the electronic components from affecting one another, **characterized in that** the outer shielding (8) rests on the inner shielding (7) and has an opening (9) in the vicinity of the inner shielding (7), so that the inner shielding in the vicinity of the opening forms at the same time the wall face of the outer shielding.

2. Electronic circuit according to Claim 1, **characterized in that** the opening (9) in the outer shielding (8) is bounded by a multiplicity of spring tongues (10) which are arranged next to one another and which rest under tension on the inner shielding (7).

3. Electronic circuit according to one of Claims 1 or 2, **characterized in that** the outer shielding (8) rests along the edge of the opening (9) with spherical impressions (11) on the inner shielding (7) and the distances between the impressions (11) are matched to the wavelength of the interfering frequencies.

4. Electronic circuit according to Claim 3, **characterized in that** the impressions (11) are provided in the spring tongues (10).

5. Electronic circuit according to at least one of the preceding claims, **characterized in that** the spring tongues (10) are bent so as to extend in a Z-shape in order to compensate different vertical positions of the shieldings (7, 8).

6. Electronic circuit according to at least one of the preceding claims, **characterized in that** the inner shielding (7) is higher than the outer shielding (8) and the Z-shaped tongues (10) of the outer shielding (8) are led upwards out of the plane of the outer shielding (8) to the plane of the inner shielding (7).

7. Electronic circuit according to at least one of the preceding claims, **characterized in that** the outer shielding (8) is mounted on a main printed circuit board (1) which is fitted, within the outer shielding (8), with a daughter printed circuit board (5) which extends parallel to and at a distance from the main printed circuit board (1) and is fitted with at least one further electronic component (6), and **in that** the inner shielding (7) is mounted on this daughter printed circuit board (5).

## Revendications

1. Circuit électronique, dans lequel sont prévus des composants électroniques, équipé d'un blindage extérieur destiné à la protection contre les ondes électromagnétiques et comportant, à l'intérieur du blindage extérieur au moins un blindage intérieur, dans lequel est emboîté un composant électronique pour sa protection contre une influence réciproque des composants électroniques, **caractérisé par le fait que** le blindage extérieur (8) s'applique sur le blindage intérieur (7) et comporte, dans la zone du blindage intérieur (7), un évidement (9) de telle sorte que le blindage intérieur constitue simultanément, dans la zone de l'évidement, la paroi du blindage extérieur.

2. Circuit électronique selon la revendication 1 **caractérisé par le fait que** l'évidement (9) du blindage extérieur (8) est limité par une pluralité de languettes flexibles (10) disposées l'une à côté de l'autre et qui s'appliquent avec une précontrainte sur le blindage intérieur (7).

3. Circuit électronique selon la revendication 1 ou 2 **caractérisé par le fait que** le blindage extérieur (8) s'applique, tout le long du bord de l'évidement (9), par des empreintes (11) en forme de calottes sphériques, sur le blindage intérieur (7) et que la distance entre les empreintes (11) est accordée sur la longueur d'onde des fréquences perturbatrices.

4. Circuit électronique selon la revendication 3 **caractérisé par le fait que** les empreintes (11) sont prévues sur les languettes flexibles (10).

5. Circuit électronique selon au moins l'une des revendications précédentes **caractérisé par le fait que** les languettes flexibles (10) sont courbées en forme de z pour compenser des différences de hauteur entre les blindages (7, 8).

6. Circuit électronique selon au moins l'une des revendications précédentes **caractérisé par le fait que** le blindage intérieur (7) est plus haut que le blindage extérieur (8) et que les languettes (10) en forme de z du blindage extérieur (8) sont guidées du plan du blindage extérieur (8) vers le plan du blindage intérieur (7).

7. Circuit électronique selon au moins l'une des revendications précédentes **caractérisé par le fait que** le blindage extérieur (8) est fixé sur une carte à circuits imprimés principale (1) qui supporte, à l'intérieur du blindage extérieur (8), une carte à circuits imprimés secondaire (5), placée en parallèle à une certaine distance de la carte à circuits imprimés principale (1) et équipée d'au moins un autre composant électronique (6), et que le blindage intérieur (7) est fixé sur cette carte à circuits imprimés secondaire (5).
